# EUROPÄISCHE PATENTSCHRIFT

(11) **EP 0 871 803 B1**
(45) Veröffentlichungstag und Bekanntmachung des Hinweises auf die Patenterteilung: **06.10.1999**
(21) Anmeldenummer: 96945764.7
(22) Anmeldetag: 21.12.1996
(51) Int. Cl.: C30B 25/02, C30B 29/22, C30B 33/00, C23C 8/10

(54) **PEROWSKIT MIT AO*(ABO3)n-SCHICHT**
PEROVSKITE WITH AO*(ABO3)n LAYER
PEROVSKITE A COUCHE AO*(ABO3)n

(30) Priorität: 05.01.1996 DE 19600218
(43) Veröffentlichungstag der Anmeldung: 21.10.1998
(73) Patentinhaber: FORSCHUNGSZENTRUM JÜLICH GMBH, 52425 Jülich (DE)
(72) Erfinder: SZOT, Krzysztof, 40-086 Katowice (PL); SPEIER, Wolfgang, 52428 Jülich (DE); HERION, Jörg, 52428 Jülich (DE)
(86) Internationale Anmeldenummer: DE9602501
(87) Internationale Veröffentlichungsnummer: WO9725457

(56) Entgegenhaltungen:
- SURFACE SCIENCE, 10 APRIL 1993, NETHERLANDS, Bd. 285, Nr. 3, ISSN 0039-6028, Seiten L510-L516, XP000653345 LIANG Y ET AL: "Atomic structures of reduced SrTiO/sub 3/(001) surfaces"
- APPLIED PHYSICS A (SOLIDS AND SURFACES), DEC. 1991, GERMANY, Bd. A53, Nr. 6, ISSN 0721-7250, Seiten 563-567, XP000653523 SZOT K ET AL: "Layer structures BaO-BaTiO/sub 3/ in the region of p-type conductivity on the surface of BaTiO/sub 3/"
- APPLIED PHYSICS LETTERS, 18 SEPT. 1995, USA, Bd. 67, Nr. 12, ISSN 0003-6951, Seiten 1775-1777, XP000653524 DOMEL R ET AL: "Resonant tunneling transport across YBa/sub 2/Cu/sub 3/O/sub 7/-SrRuO/sub 3/ interfaces"

## Beschreibung

Die Erfindung bezieht sich auf einen Perowskiten vom Typ ABO₃. Es handelt sich dabei beispielsweise um die Perowskite SrTiO₃, BaTiO₃, PbTiO₃ oder KNbO₃. Des weiteren bezieht sich die Erfindung auf ein Herstellungsverfahren für den erfindungsgemäßen Perowskiten.

Es ist bekannt, Perowskite als Substrat bei einkristallinem Schichtwachstum oder als Material bei Hochtemperatur-Brennstoffzellen einzusetzen.

Perowskite weisen an ihrer Oberfläche Vertiefungen oder Erhebungen in der Größenordnung ihrer Gitterparameter c = 4 Å auf. Diese Abweichungen von einer glatten Fläche beeinträchtigen nachteilhaft einkristallines Schichtwachstum auf den Perowskiten.

Des weiteren wird die Lebensdauer eines in einer Hochtemperatur-Brennstoffzelle eingesetzten Perowskits durch die chemisch aggressive Umgebung begrenzt.

Aufgabe der Erfindung ist die Schaffung eines Perowskiten, der sich chemisch stabiler verhält und in verbesserter Weise als Substrat für das einkristalline Schichtwachstum einsetzbar ist, sowie die Schaffung eines diesbezüglichen Herstellungsverfahren.

Gelöst wird die Aufgabe durch einen Perowskiten mit den Merkmalen des Hauptanspruchs sowie durch ein Verfahren mit den Merkmalen des Nebenanspruchs. Eine Lösung der Aufgabe stellt ferner eine Schichtstruktur mit den Merkmalen des Nebenanspruchs dar.

Gemäß Hauptanspruch weist ein Perowskit vom Typ ABO₃ eine AO*(ABO₃)ₙ-Schicht, hergestellt bei hohen Temperaturen unter oxidierender Atmosphäre gemäß Ausführungsbeispiel, an seiner Oberfläche auf. AO*(ABO₃)ₙ ist als Ruddlesden-Popper Phase bekannt. Die Schicht ist terrassenförmig aufgebaut, d. h. sie weist an ihrer Oberfläche abgegrenzte flächenförmige Bereiche auf, die durch Stufen voneinander getrennt sind. Die Höhe der Stufen entspricht den Gitterparametern der Ruddlesden-Popper Phase mit bestimmtem n in c*-Richtung der Einheitszelle. c*= (2n+1)c stellt den Gitterparameter der Ruddlesden-Popper Phase dar. c ist der Gitterparameter des ursprünglichen Perowskiten. Die flächenförmigen Bereiche sind frei von den Erhebungen oder Vertiefungen der Größenordnung 4 Å, die beim eingangs genannten Perowskiten auftreten. Von der anspruchsgemäßen Schicht ist ein nachfolgend beschriebenes, streifenförmiges oder inselförmiges Auftreten einer AO*(ABO₃)ₙ-Phase zu unterscheiden.

Die terrassenförmig aufgebaute AO*(ABO₃)ₙ-Schicht verhält sich chemisch stabiler als ein einfacher Perowskit vom Typ ABO₃. Daher eignet sich dieses neue Material in verbesserter Weise für eine Verwendung in einer chemisch oxidierenden Atmosphäre, also z. B. in einer Atmosphäre, die starke Segregrationen an Komponenten von Perowskiten verursachen. Eine solche Atmosphäre herrscht insbesondere in Hochtemperatur-Brennstoffzellen und zwar vor allem auf der Kathodenseite. Zur Vermeidung von Alterungsprozessen werden daher anstelle einfacher Perowskite vom Typ ABO₃ vorteilhaft Perowskite mit AO*(ABO₃)ₙ-Oberflächenschutzschichten in Hochtemperatur-Brennstoffzellen- z. B. in Form einer Elektrode - verwendet.

Wird nun z. B. ein Perowskit mit einer AO*(ABO₃)ₙ-Oberflächenschicht mit n=1 hergestellt, so treten terrassenförmige Strukturen an seiner Oberfläche auf, deren Höhenunterschiede 12 Å betragen. Es ist nun in verbesserter Weise als bisher möglich, auf eine solche Schicht beispielsweise einkristallines YBa₂Cu₃O₇ aufwachsen zu lassen. Die Verbesserung ist möglich, da die Gitterkonstante von YBa₂Cu₃O₇ ungefähr 11,6 - 11,7 Å beträgt und somit vergleichbar mit der Stufenhöhe der terrassenförmigen Strukturen ist.

Das Auftreten neuer Phasen wie Srₙ₊ᵢTiₙO₃ₙ₊₁ beim Perowskiten SrTiO₃ ist z. B. aus Surface Science Letters 285 (1993) L510-L516 bekannt. Diese Phase wurde unter reduzierten Bedingungen erzielt und wächst senkrecht zur Oberfläche. Sie tritt streifenförmig auf. Es handelt sich daher nicht um eine Schicht. Ferner liegt keine Ruddlesden-Popper Phase vor.

Unbekannt ist das Auftreten sowie die Herstellung von Ruddlesden-Popper Phasen als terrassenförmig aufgebaute, sich über die Oberfläche eines Perowskiten erstreckende Schichten mit einstellbaren Stufenhöhen (2n+1)c. Ferner ist unbekannt, AO*(ABO₃)ₙ-Phasen als Schutzschicht oder als Mittel zur Verbesserung einkristallinen Schichtwachstums einzusetzen.

Schichtstrukturen, bestehend aus einem Perowskiten vom Typ ABO₃ mit einer AO*(ABO₃)ₙ-Oberflächenschicht als Substrat sowie mit einer einkristallinen Schicht auf der AO*(ABO₃)ₙ-Schicht, weisen eine höhere Qualität sowie eine geringere Anzahl von Stapelfeldern durch Anpassung der c*-Gitterkonstante (= Gitterparametern der Ruddlesden-Popper Phase) an die Gitterkonstante der einkristallinen Schicht auf. Je besser die jeweiligen Gitterkonstanten aneinander angepaßt sind, desto höher ist die erreichbare Schichtqualität.

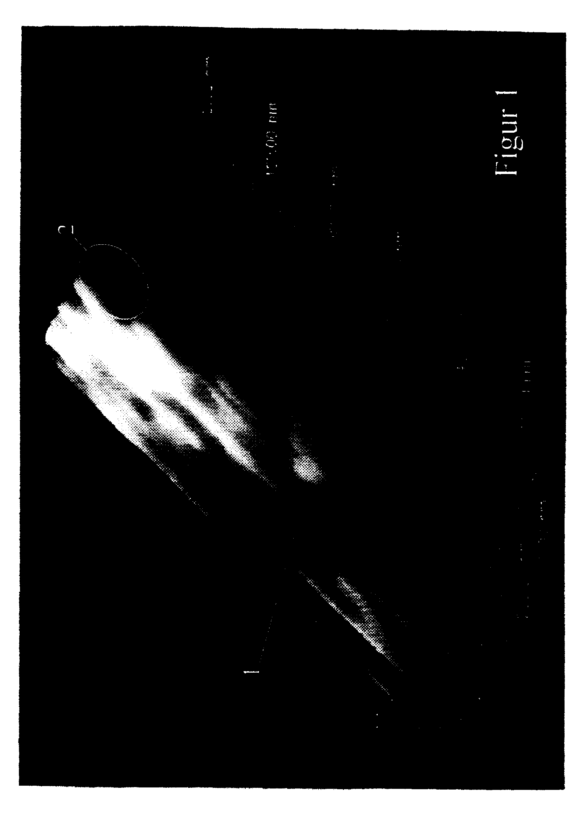

Figur 1 zeigt eine Aufnahme einer AO*(ABO₃)ₙ-Schicht. Hergestellt wurden AO*(ABO₃)ₙ-Schichten für die Perowskite SrTiO₃, BaTiO₃, PbTiO₃ oder KNbO₃, indem diese einer oxidierenden Umgebung (insbesondere einer O₂-Umgebung bei Drücken von 1-200 mbar) und einer Temperatur von 800 bis 950 °C ausgesetzt wurden. Unter den vorgenannten Bedingungen wächst die AO*(ABO₃)ₙ -Phase parallel zur (100)-Oberfläche auf. In Abhängigkeit von der gewählten Temperatur und dem gewählten Sauerstoffdruck bilden sich auf der Perowskitoberfläche gleichmäßige AO*(ABO₃)ₙ-Schichten mit terrassenförmiger Struktur (Ruddlesden-Popper Phase) sowie mit definiertem n. n=1 war die thermodynamisch stabilste Phase unter oxidierenden Bedingungen und zwar sowohl im Vergleich zum Perowskiten der eingangs genannten Art als auch im Vergleich zu Ruddlesden-Popper Phasen mit höherem n.

Bei niedrigen Drücken von z. B. 1 mbar wurden Ruddlesden-Popper Phasen mit höherem n von z. B. n= 4, 5 oder 6 erzielt.

Ab 500 °C trat das Wachstum von Ruddlesden-Popper Phasen inselförmig auf. Zur Erzielung von Schichten waren höhere Temperaturen notwendig. Um homogene Beschichtungen zu erzielen ist z. B. bei SrTiO₃ eine Mindesttemperatur von ca. 750 °C erforderlich. Bei Drücken von 100 bis 200 mbar sowie bei Temperaturen von 800 bis 950 °C wurden nach ein bis zwei Stunden Ruddlesden-Popper Phasen mit n= 1 erzielt. Hergestellt wurden so Schichtdikken von 200 bis 300 Å.

Figur 1 zeigt eine AFM-Aufnahme im Kontakt-Mode einer AO*(ABO₃)ₙ-Oberfläche 1 mit n=1 eines Perowskiten vom Typ ABO₃. Charakteristisch für diese Oberfläche ist der terrassenförmige Aufbau mit Stufen 2, deren Höhe 12 Å beträgt.

Hergestellt wurden ferner YBa₂Cu₃O₇-Schichten auf der Sr₂TiO₄-Oberfläche (c* ≈ 11,8 Å) eines SrTiO₃-Substrates sowie auf der Pb₂TiO₄-Oberfläche (c* ≈ 11,91 Å) eines PbTiO₃-Substrates. Die Schichtdicken von Sr₂TiO₄ sowie von Pb₂TiO₄ betrugen ca. 200 bis 300 Å.

## Patentansprüche

1. Substrat bestehend aus einem Perowskiten vom Typ ABO₃ mit einer AO*(ABO₃)ₙ-Oberflächenschicht.

2. Substrat nach vorhergehendem Anspruch mit einer einkristallinen Schicht auf der AO*(ABO₃)ₙ-Schicht.

3. Verfahren zur Herstellung eines anspruchsgemäßen Substrates, indem ein Substrat, bestehend aus einem Perowskiten vom Typ ABO₃, bei Temperaturen von 800 bis 950 °C einer oxidierenden O₂-Umgebung bei Drücken von 1 bis 200 mbar ausgesetzt wird.

## Claims

1. A substrate consisting of a perovskite of the ABO₃ type having an AO*(ABO₃)ₙ surface layer.

2. A substrate according to the preceding claim, having a monocrystalline layer on the AO*(ABO₃)ₙ layer.

3. A process for the production of a substrate according to the claims, by subjecting a substrate consisting of a perovskite of the ABO₃ type to an oxidising O₂ environment at pressures from 1 to 200 mbar and at temperatures from 800 to 950°C.

## Revendications

1. Substrat constitué d'une perovskite de type ABO₃ ayant une couche superficielle en AO*(ABO₃)ₙ.

2. Substrat suivant la revendication précédente, ayant une couche monocristalline sur la couche en AO*(ABO₃)ₙ.

3. Procédé de préparation d'un substrat suivant les revendications, qui consiste à soumettre un substrat constitué d'une perovskite de type ABO₃ à des températures de 800 à 950°C à une atmosphère d'O₂ oxydante sous des pressions des 1 à 200 mbar.
